# EUROPEAN PATENT APPLICATION

(11) **EP 3 051 380 A1**
(43) Date of publication of application: **03.08.2016**
(21) Application number: 16152613.2
(22) Date of filing: 25.01.2016
(51) Int. Cl.: G06F 1/16, C23C 14/08

(54) **HOUSING, METHOD OF MANUFACTURING THE SAME, AND ELECTRONIC DEVICE INCLUDING THE SAME**

(30) Priority: 30.01.2015 KR 20150015402
(71) Applicant: Samsung Electronics Co., Ltd., Gyeonggi-do 16677 (KR)
(72) Inventor: Han, Seung-Soo, Seoul (KR); Ji, Young-Bae, Yongin-si (KR); Lee, Byoung-Soo, Suwon-si (KR)
(74) Representative: Nederlandsch Octrooibureau

(57) **Abstract**

The present disclosure provides a housing of an electronic device and a method of manufacturing the housing. The method includes forming a basic material of the housing by coupling members of the housing composed of dissimilar materials, planarizing a coupling surface of the basic material of the housing, forming at least one deposition film on the planarized surface, and forming a painting film on the at least one deposition film.

## Description

### 1. Field of the Disclosure

The present disclosure generally relates to an electronic device, and more particularly, to a housing, a method of manufacturing the housing, and an electronic device including the housing.

### 2. Description of the Related Art

Recently, with the development of electronic communication technologies, electronic devices having various functions have appeared on the market. These electronic devices generally have a convergence function for complexly performing one or more functions.

In recent years, as the functional gaps between the manufacturers have been significantly reduced, considerable effort has been made to increase the strength of electronic devices, which are becoming gradually slimmer to satisfy consumer demand and to reinforce design aspects of the electronic devices. Such efforts have led to the manufacturing of electronic devices with at least a portion of the electronic device being realized in a metal material to make the electronic device luxurious and appealing. Additionally, the use of a metal material in the electronic device, also serves to solve other problems, such as vulnerability in the strength of the device, grounding problems (for example, preventing a user of the electronic device from receiving an electric shock), and antenna radiation performance reduction problems.

Conventionally, housings for such electronic devices, are manufactured by coupling two members of dissimilar materials, and then laminating, on the border surface of the coupled part of the two members, multiple primer layers of different colors to overcome a sense of difference of the border surface of the coupled part, and to minimize a transmissivity difference between the dissimilar materials of the coupled parts. However, with the conventional method, it is difficult to implement an appealing painting surface, and as a result, the value of the design of the electronic device is lowered due to clustering of the primer layers and a resulting low glossiness; and manufacturing process costs also increase.

### SUMMARY

The present disclosure has been made to address at least the problems and disadvantages described above, and to provide at least the advantages described below.

Accordingly, an aspect of the present disclosure is to provide a housing for an electronic device that can prevent degradation of design by applying a single primer layer.

Accordingly, another aspect of the present disclosure is to provide a housing for an electronic device that contributes to an appealing external appearance by minimizing a difference between transmissivities of a border surface due to coupling of two members of dissimilar materials.

Accordingly, another aspect of the present disclosure is to provide a housing for an electronic device that contributes to the slimness of the device by excluding a plurality of primer layers.

In accordance with an aspect of the present disclosure, there is provided a method of manufacturing a housing of an electronic device. The method includes forming a basic material of the housing by coupling members of the housing composed of dissimilar materials, planarizing a coupling surface of the basic material of the housing, forming at least one deposition film on the planarized surface, and forming a painting film on the at least one deposition film.

In accordance with another aspect of the present disclosure, there is provided a housing of an electronic device. The housing includes a basic material formed by coupling members of the housing composed of dissimilar materials, wherein a coupling surface of the basic material of the housing is planarized, at least one deposition film formed on the planarized surface, and a painting film on the at least one deposition film.

In accordance with another aspect of the present disclosure, there is provided an electronic device. The electronic device includes a housing forming at least a portion of an external surface of the electronic device, wherein the housing includes a first member, a second member coupled to the first member to form a basic material of the housing, a primer layer laminated on the basic material of the housing, at least one deposition film laminated on the primer layer, and a painting film laminated on the at least one deposition film.

### BRIEF DESCRIPTION OF THE DRAWINGS

The above and other aspects, features, and advantages of the present disclosure will be more apparent from the following detailed description taken in conjunction with the accompanying drawings, in which:
FIG. 1 illustrates a network environment including an electronic device, according to an embodiment of the present disclosure;
FIG. 2A is a perspective view illustrating a front surface of an electronic device, according to an embodiment of the present disclosure;
FIG. 2B is a perspective view illustrating a rear surface of an electronic device, according to an embodiment of the present disclosure;
FIG. 3 is a flowchart of a method of manufacturing a housing of an electronic device, according to an embodiment of the present disclosure;
FIG. 4A is a view illustrating a metal member of a housing of an electronic device, according to an embodiment of the present disclosure;
FIG. 4B is a view illustrating a state in which a non-metal member and a metal member of a housing of an electronic device are dually injection-molded together, according to an embodiment of the present disclosure;
FIGs. 5A to 5E are diagrams illustrating a procedure of manufacturing a housing of an electronic device, according to an embodiment of the present disclosure;
FIGs. 6A and 6B are sectional views of a housing of an electronic device, according to an embodiment of the present disclosure;
FIG. 7 is a view illustrating a pattern shape of a deposition film formed in a non-metal member of a housing of an electronic device, according to an embodiment of the present disclosure; and
FIG. 8 is a block diagram illustrating a configuration of an electronic device, according to an embodiment of the present disclosure.

### DETAILED DESCRIPTION OF EMBODIMENTS OF THE PRESENT

### DISCLOSURE

Hereinafter, various embodiments of the present disclosure will be described with reference to the accompanying drawings. However, it should be understood that there is no intent to limit the present disclosure to the particular forms disclosed herein; rather, the present disclosure should be construed to cover various modifications, equivalents, and/or alternatives of embodiments of the present disclosure. In describing the drawings, similar reference numerals may be used to designate similar constituent elements.

As used herein, the expressions "have", "may have", "include", or "may include" refer to the existence of a corresponding feature (e.g., numeral, function, operation, or constituent element, such as component), and do not exclude one or more additional features.

In the present disclosure, the expressions "A or B", "at least one of A or/and B", and "one or more of A or/and B" may include all possible combinations of the items listed. For example, the expressions "A or B", "at least one of A and B", and "at least one of A or B" refer to all of (1) including A, (2) including B, or (3) including all of A and B.

Expressions, such as "a first", "a second", "the first", or "the second", used herein may modify various components regardless of the order and/or the importance, but does not limit the corresponding components. For example, a first user device and a second user device indicate different user devices although both of them are user devices. For example, a first element may be referred to as a second element, and similarly, a second element may be referred to as a first element without departing from the scope of the present disclosure.

It should be understood that when an element (e.g., first element) is referred to as being (operatively or communicatively) "connected," or "coupled," to another element (e.g., second element), the first element may be directly connected or coupled directly to the second element or any other element (e.g., third element) may be interposed between the two elements. In contrast, it may be understood that when an element (e.g., first element) is referred to as being "directly connected," or "directly coupled" to another element (second element), there are no element (e.g., third element) interposed between the two elements.

The expression "configured to" used herein may be exchanged with, for example, "suitable for", "having the capacity to", "designed to", "adapted to", "made to", or "capable of" according to the situation. The term "configured to" does not necessarily imply "specifically designed to" in hardware. Alternatively, in some situations, the expression "device configured to" may mean that the device, together with other devices or components, "is able to". For example, the phrase "processor configured (or adapted) to perform A, B, and C" may refer to a dedicated processor (e.g. an embedded processor) only for performing the corresponding operations or a generic-purpose processor (e.g., a central processing unit (CPU) or application processor (AP)) that can perform the corresponding operations by executing one or more software programs stored in a memory device.

The terms used herein are merely for the purpose of describing particular embodiments of the present disclosure and are not intended to limit the scope of other embodiments. As used herein, singular forms may include plural forms as well unless the context clearly indicates otherwise. Unless defined otherwise, all terms used herein, including technical and scientific terms, have the same meaning as those commonly understood by a person skilled in the art to which the present disclosure pertains. Terms such as those defined in a generally used dictionary may be interpreted to have meanings the same as the contextual meanings in the relevant field of art, and are not to be interpreted to have ideal or excessively formal meanings unless clearly defined herein. In some cases, even a term defined in the present disclosure should not be interpreted to exclude embodiments of the present disclosure.

An electronic device, according to various embodiments of the present disclosure, may include at least one of a smart phone, a tablet Personal Computer (PC), a mobile phone, a video phone, an electronic book reader (e-book reader), a desktop PC, a laptop PC, a netbook computer, a workstation, a server, a Personal Digital Assistant (PDA), a Portable Multimedia Player (PMP), a MPEG-1 audio layer-3 (MP3) player, a mobile medical device, a camera, and a wearable device. The wearable device may include at least one of an accessory type (e.g., a watch, a ring, a bracelet, an anklet, a necklace, a glasses, a contact lens, or a Head-Mounted Device (HMD)), a fabric or clothing integrated type (e.g., an electronic clothing), a body-mounted type (e.g., a skin pad, or tattoo), and a bio-implantable type (e.g., an implantable circuit).

According to some embodiments of the present disclosure, the electronic device may be a home appliance. The home appliance may include at least one of, for example, a television, a Digital Versatile Disk (DVD) player, an audio player, a refrigerator, an air conditioner, a vacuum cleaner, an oven, a microwave oven, a washing machine, an air cleaner, a set-top box, a home automation control panel, a security control panel, a TV box (e.g., Samsung HomeSync™, Apple TV™, or Google TV™), a game console (e.g., Xbox™ and PlayStation™), an electronic dictionary, an electronic key, a camcorder, and an electronic photo frame.

According to another embodiment of the present disclosure, the electronic device may include at least one of various medical devices (e.g., various portable medical measuring devices (a blood glucose monitoring device, a heart rate monitoring device, a blood pressure measuring device, a body temperature measuring device, etc.), a Magnetic Resonance Angiography (MRA) machine, a Magnetic Resonance Imaging (MRI) machine, a Computed Tomography (CT) machine, and an ultrasonic machine), a navigation device, a Global Positioning System (GPS) receiver, an Event Data Recorder (EDR), a Flight Data Recorder (FDR), a Vehicle Infotainment device, an electronic device for a ship (e.g., a navigation device for a ship, and a gyro-compass), an avionics device, a security device, an automotive head unit, a robot for home or industry, an automatic teller's machine (ATM), a point of sales (POS) machine, or an Internet of Things (IoT) device (e.g., a light bulb, various sensors, an electric or gas meter, a sprinkler device, a fire alarm, a thermostat, a streetlamp, a toaster, sporting goods, a hot water tank, a heater, a boiler, etc.).

According to some embodiments of the present disclosure, the electronic device may include at least one of a part of furniture or a building/structure, an electronic board, an electronic signature receiving device, a projector, and various kinds of measuring instruments (e.g., a water meter, an electric meter, a gas meter, and a radio wave meter).

The electronic device, according to various embodiments of the present disclosure, may be a combination of one or more of the aforementioned various devices. The electronic device may be a flexible device. Further, the electronic device is not limited to the aforementioned devices, and may include a new electronic device according to the development of new technologies.

Hereinafter, an electronic device, according to various embodiments of the present disclosure, will be described with reference to the accompanying drawings. As used herein, the term "user" may indicate a person who uses an electronic device or a device (e.g., an artificial intelligence electronic device) that uses an electronic device.

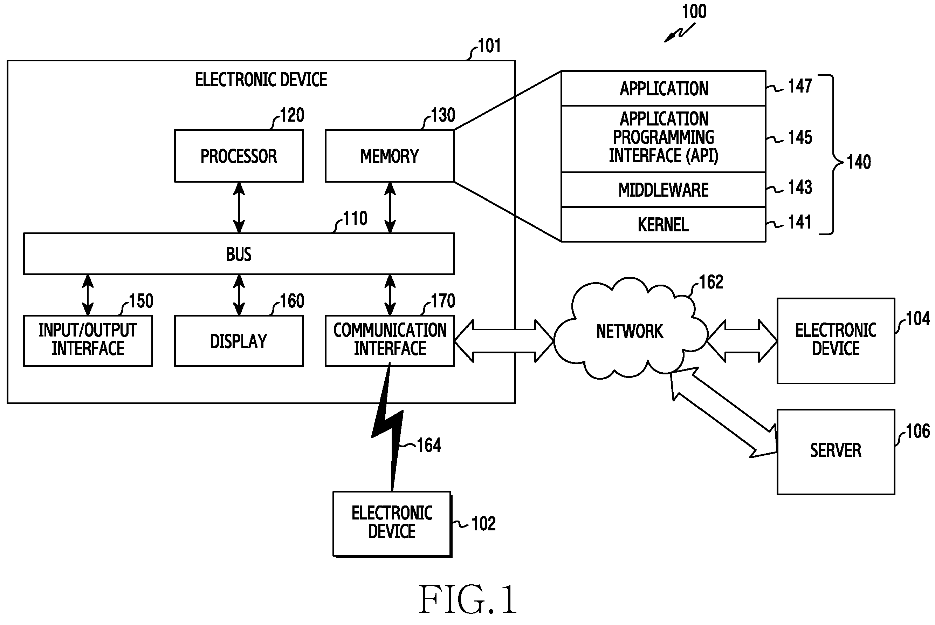

FIG. 1 illustrates a network environment including an electronic device, according to an embodiment of the present disclosure.

Referring to FIG. 1, a network environment 100 including an electronic device 101 is provided. The electronic device 101 includes a bus 110, a processor 120, a memory 130, an input/output interface 150, a display 160, and a communication interface 170. The electronic device 101 may omit at least one of the above-mentioned components or may additionally include other components.

The bus 110 includes a circuit that connects the above-mentioned components of the electronic device 110 (i.e. a processor 120, a memory 130, an input/output interface 150, a display 160, and a communication interface 170) and transmits communication (e.g., a control message and/or data) between the components.

The processor 120 includes one or more of a Central Processing Unit (CPU), an Application Processor (AP), and a Communication Processor (CP). The processor 120 executes an arithmetic operation or data processing related to a control and/or communication of one or more other components of the electronic device 101.

The memory 130 includes a volatile memory and/or a non-volatile memory. The memory 130 stores commands or data related to one or more other components of the electronic device 101. The memory 130 stores software and/or a program 140. The program 140 includes, for example, a kernel 141, a middleware 143, an Application Programming Interface (API) 145, and/or an application (or an "application program") 147. At least one of the kernel 141, the middleware 143, and the API 145 may be referred to as an Operating System (OS).

The kernel 141 controls or manages system resources (e.g., the bus 110, the processor 120, or the memory 130) that are used for executing operations or functions implemented in the other programs (e.g., the middleware 143, the API 145, or the application programs 147). In addition, the kernel 141 may provide an interface that allows the middleware 143, the API 145, or the application program 147 to access individual components of the electronic device 101 so as to control or manage the system resources.

The middleware 143 plays an intermediary role such that the API 145 or the application programs 147 may communicate with the kernel 141 so as to exchange data.

In addition, the middleware 143 processes one or more task requests received from the program 147 according to a priority. For example, the middleware 143 may assign, to at least one of the application programs 147, a priority for using a system resource of the electronic device 101 (e.g., the bus 110, the processor 120, or the memory 130). For example, the middleware 143 processes task requests so as to perform scheduling, load balancing, or the like for the task requests, according to the priority assigned to the at least one of the application programs 147.

The API 145 is an interface for allowing the application 147 to control functions provided by the kernel 141 or the middleware 143 and may include at least one interface or function (e.g., commands) for a file control, a window control, an image processing, or a character control.

The input/output interface 150 serves as an interface that is capable of delivering commands or data, entered from a user or an external device, such as a first external electronic device 102, a second external electronic device 104, or a server 106, to the other components of the electronic device 101. Also, the input/output interface 150 outputs commands or data received from the other components of the electronic device 101 to the user or the external device, such as a first external electronic device 102, a second external electronic device 104, or a server 106.

The display 160 includes, for example, a Liquid Crystal Display (LCD), a Light Emitting Diode (LED) display, an Organic Light Emitting Diode (OLED) display, or a MicroElectroMechanical systems (MEMS) display, or an electronic paper display. The display 110 displays various contents (e.g., text, image, video, icon, or symbol) to, for example, the user. The display 110 includes a touch screen, and receives a touch input, a gesture input, a proximity input, or a hovering input using, for example, an electronic pen or a part of a user's body.

The communication interface 170 sets communication between the electronic device 101 and the first external electronic device 102, the second external device 104, and the server 106. For example, the communication interface 170 communicates with the second external electronic device 104 and the server 106 by being connected with a network 162 through wired or wireless communication.

The wireless communication may use at least one of, for example, LTE (Long-Term evolution), LTE-A (LTE Advance), CDMA (Code Division Multiple Access), WCDMA (Wideband CDMA), UMTS (Universal Mobile Telecommunication System), WiBro (Wireless Broadband), or GSM (Global System for Mobile communication). In addition, the wireless communication includes, for example, short distance communication 164.

The short distance communication 164 includes at least one of WiFi, Bluetooth, NFC (Near Field Communication), and GPS (Global Positioning System). The wired communication may use at least one of, for example, USB (Universal Serial Bus), HDMI (High Definition Multimedia Interface), RS-232 (Recommended Standard 232), and POTS (Plain Old Telephone Service).

The network 162 includes a telecommunication network at least one of a computer network (e.g., Local Area Network (LAN) or Wide Area Network (WAN)), Internet, and a telephone network.

Each of the first external electronic device 102 and the second external electronic device 104 may be a type of device that is the same as or different from the electronic device 101.

The server 106 may include a group of one or more servers.

All or some of the operations to be executed by the electronic device 101 may be executed by the first external electronic devices 102, the second external electronic device 104 or the server 106. In the case where the electronic device 101 should perform a certain function or service automatically or by request, the electronic device 101 may request some functions that are associated with the electronic device 101 from the first external electronic devices 102 and the second external electronic device 104 or the server 106 instead of or in addition to executing the function or service by itself. In this case, the first external electronic device 102, the second external electronic device 104, or the server 106 executes the requested functions or additional functions, and transmits the results to the electronic device 101. The electronic device 101 provides the requested functions or services by processing the received results as they are or by additionally processing the received results. For this purpose, for example, a cloud computing technique, a distributed computing technique, or a client-server computing technique may be used.

Various embodiments of the present disclosure describe an external housing of an electronic device in which a non-metal member and a metal member (for example, a metal bezel) are formed through dual injection-molding; however, the present disclosure is not limited thereto. For example, the present disclosure may be applied to housings of various devices other than an electronic device, and may also contribute to an internal housing.

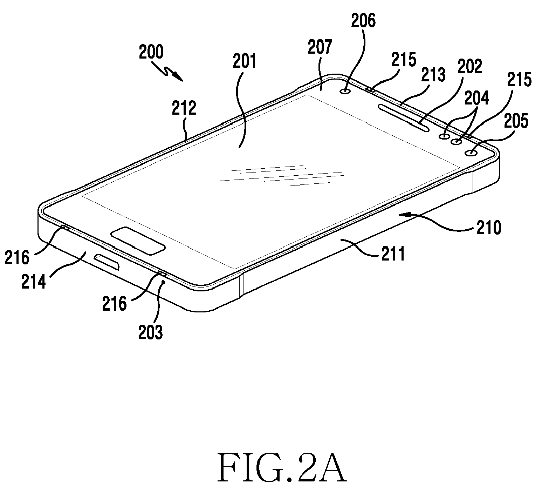

FIG. 2A is a perspective view illustrating a front surface of an electronic device, according to an embodiment of the present disclosure. Referring to FIG. 2A, an electronic device 200 is provided. A display 201 is installed on a front surface 207 of the electronic device 200. A speaker unit 202 for outputting a voice of a counterpart is installed above the display 201. A microphone unit 203 for transmitting a voice of a user of an electronic device to a counterpart is installed below the display 201.

Components for performing various functions of the electronic device 200 may be arranged around the speaker unit 202.

The components may include one or more sensor modules 204, a camera unit 205, and an LED indicator 206.

The sensor module 204 includes at least one of, for example, an illumination intensity sensor (for example, a light sensor), a proximity sensor, an infrared ray sensor, and an ultrasonic wave sensor.

The LED indicator 206 is for allowing a user of the electronic device 200 to recognize state information of the electronic device 200.

The electronic device 200 includes a metal member 210 (for example, may contribute to at least a portion of the dually injection-molded housing as a metal bezel). The metal member 210 is arranged along a periphery of the electronic device 200, and extends to the periphery and at least a portion of the rear surface of the electronic device 200. The metal member 210 defines the thickness of the electronic device 200 along the periphery of the electronic device 200, and is formed in a loop. However, the present disclosure is not limited thereto, and the metal member 210 may contribute to at least a portion of the thickness of the electronic device 200. The metal member 210 may be arranged only in at least an area of the periphery of the electronic device 200. The metal member 210 includes one or more segmental parts 215 and 216, and the unit metal members, i.e. the lower metal member 214 and the upper metal member 213 separated by the segmental parts 215 and 216 may be utilized as antenna radiation bodies.

The metal member 210 has a loop shape along the periphery, and contributes to the entire thickness of the electronic device 200. When the electronic device 200 is viewed from the front side, the metal member 210 may have a right metal member 211, a left metal member 212, an upper metal member 213, and a lower metal member 214. Here, the above-described lower metal member 214 and upper metal member 213 may contribute as unit metal members formed by the segmental parts 215 and 216.

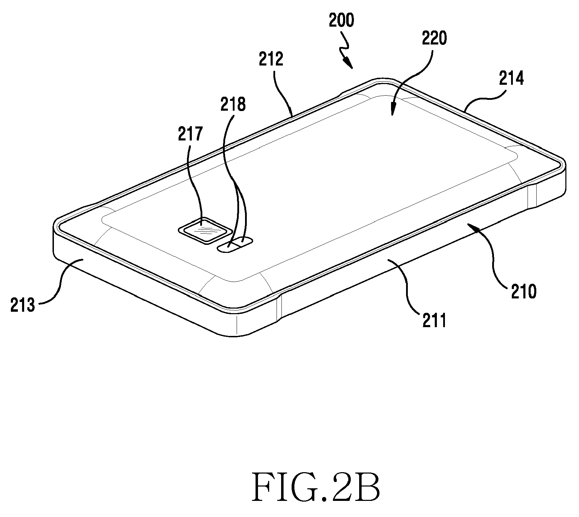

FIG. 2B is a perspective view illustrating a rear surface of an electronic device, according to an embodiment of the present disclosure.

Referring to FIG. 2B, a cover member 220 is arranged on the rear surface of the electronic device 200. At least a portion of the cover member 220 is integrally formed with the metal member 210 to contribute as a housing of the electronic device 200. However, the present disclosure is not limited thereto, and the cover member 220 may be a battery cover for protecting a battery pack detachably installed in the electronic device 200 and making the external appearance of the electronic device 200 appealing. A camera unit 217 and a flash 218 are arranged on the rear surface of the electronic device 200.

The housing may extend to at least some portions of the metal member 210 and the cover member 220. The housing may be formed by coupling the two members having dissimilar materials. The members of dissimilar materials includes the metal member 210, and the cover member 220 composed of various materials, such as glass, composite materials (GFRP, CFRP), a synthetic resin, and ceramic, which is coupled to the metal member 210. The metal member 210 and the cover member 220, composed of dissimilar materials, may form one housing through various methods. For example, the metal member 210 and the cover member 220 may be coupled to each other through various methods such as dual injection-molding, insert injection-molding, and mechanical coupling.

Because the housing formed of dissimilar materials has different transmissivities, a visual sense of difference can be removed by forming a deposition film and laminating a painting film on the deposition film. Because a plurality of primer layers for removing the visual sense of difference are excluded by forming a deposition film on the housing formed of dissimilar materials, a manufacturing process becomes simplified and manufacturing costs are reduced.

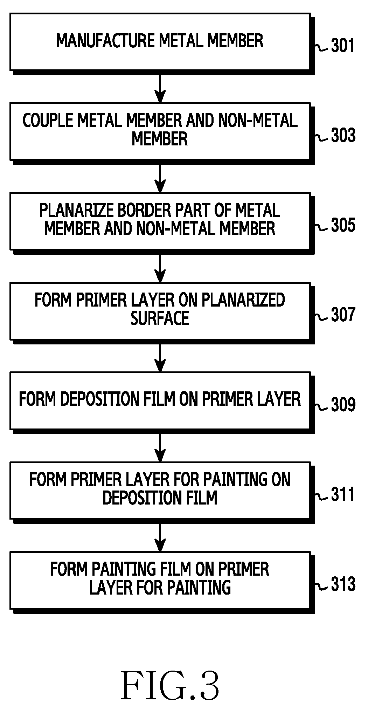

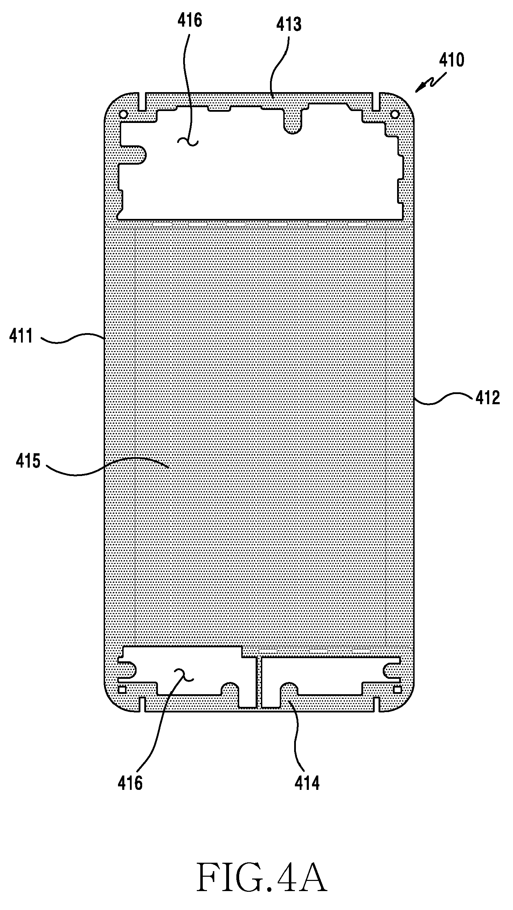

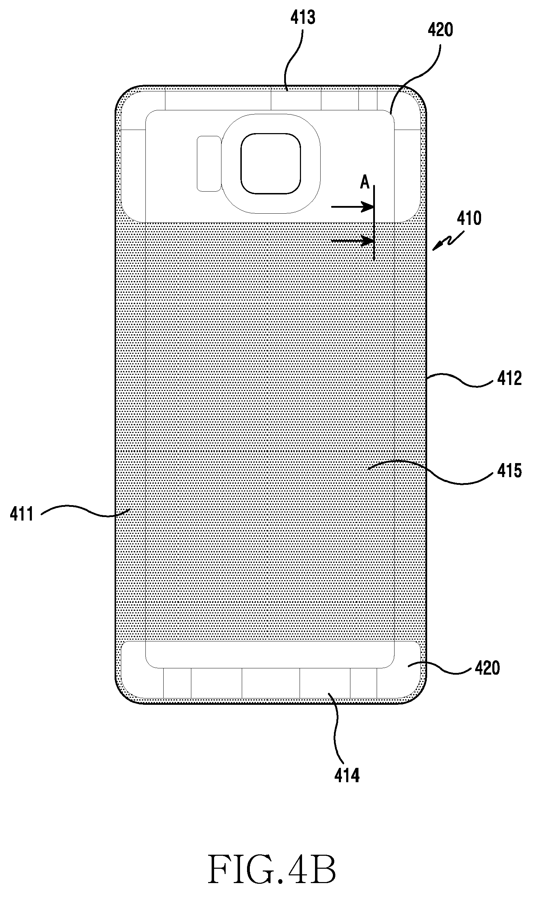

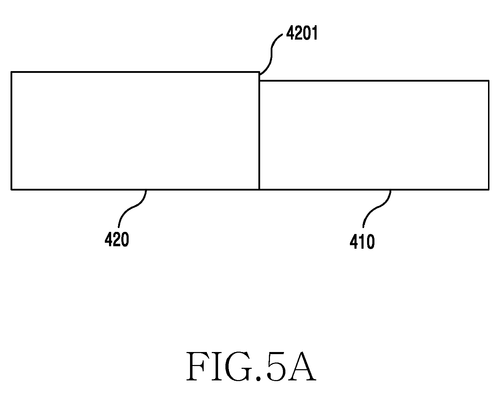

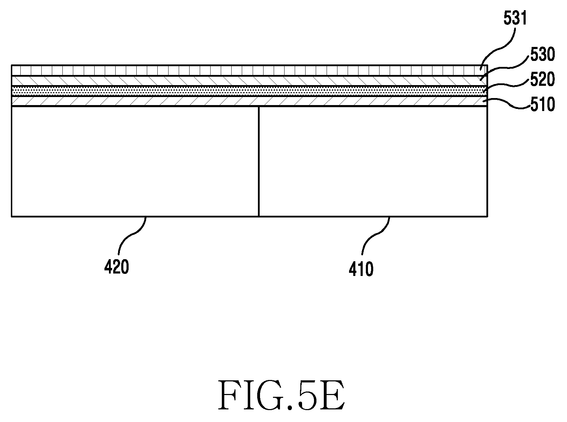

FIG. 3 is a flowchart of a method of manufacturing a housing of an electronic device, according to an embodiment of the present disclosure. FIG. 4A is a view illustrating a metal member of a housing of an electronic device, according to an embodiment of the present disclosure. FIG. 4B is a view illustrating a state in which a non-metal member and a metal member of a housing of an electronic device are dually injection-molded together, according to an embodiment of the present disclosure. FIGs. 5A to 5E are diagrams illustrating a procedure of manufacturing a housing of an electronic device, according to an embodiment of the present disclosure. Referring to FIGs. 3, 4A to 4B, and 5A to 5E, a process for manufacturing the housing of electronic device 200, as shown with reference to FIGs. 4A to 5B, will be described with reference to FIG. 3. FIGs. 5A to 5E are sectional views taken along line A of FIG. 4B.

Referring to FIG. 3, in step 301, as illustrated in FIG. 4A, a metal member 410 having a predetermined shape may be manufactured. The metal member 410 may be formed of various materials such as aluminum, magnesium, and Steel Use Stainless (SUS). The metal member 410 may be finished as a desired product through casting or pressing. The metal member 410 includes a left metal member 412, a right metal member 411, an upper metal member 413, and a lower metal member 414 that contribute to the periphery of the electronic device 200, and one or more of the metal member 410 extends to a cover member area 415. The metal member 410 includes an opening area 416 into which the non-metal member 420 (shown in FIG. 4B) is injection-molded.

Thereafter, in step 303, as illustrated in FIG. 4B, the metal member 410 and the non-metal member 420 are coupled to each other. The metal member 410 and the non-metal member 420 may be coupled to each other through dual injection-molding or insert injection-molding.

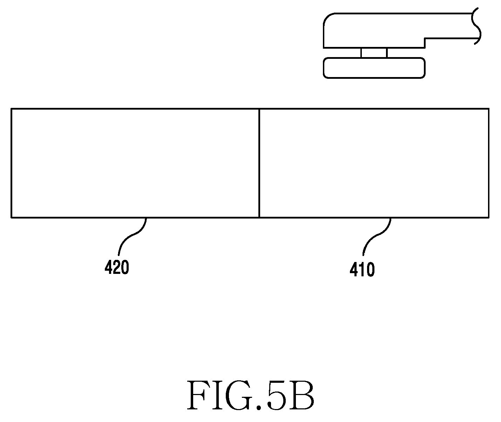

Thereafter, in step 305, as illustrated in FIGS. 5A and 5B, planarization is performed on a border surface where the metal member 410 and the non-metal member 420 are coupled. The planarization includes buffing for eliminating a step 4201 formed on the border surface of the metal member 410 and the non-metal member 420. The planarization of the metal member 410 and the non-metal member 420 may be performed on the entire surface as well as on the border surface.

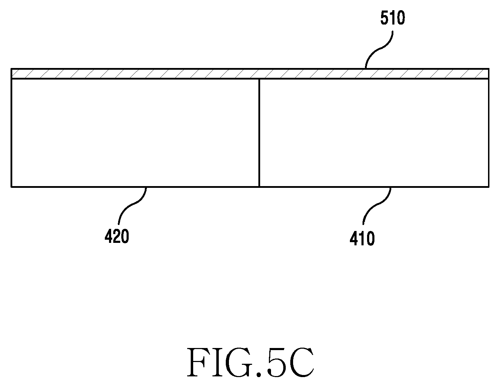

Thereafter, in step 307, as illustrated in FIG. 5C, a primer layer 510 is formed on the planarized surfaces of the metal member 410 and the non-metal member 420. The primer layer 510 may be formed of one or more of olefin-based, acryl-based, and urethane-based materials.

The primer layer 510 is formed by painting a solvent, such as glass, an acryl-based material, or an SiO2-based material, such as urethane. However, the present disclosure is not limited thereto, and the primer layer 510 may be formed by a transparent urethane paint. The process of forming the primer layer 510 involves performing a deposition process, which functions to uniformly and smoothly apply and stick a deposition material to the surface of the housing. The housing coated with the primer layer 510 may be cured through a drying process by an oven or through a natural drying process.

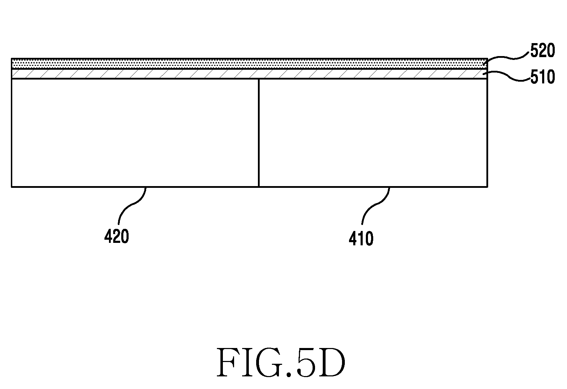

Thereafter, in step 309, as illustrated in FIG. 5D, after the primer layer 510 is cured, a deposition film 520 is applied on the primer layer 510. According The deposition method includes Physical Vapor Deposition (Ph D) and Chemical Vapor Deposition (CVD). The deposition film 520 is formed of at least one of Ti-based, Sn-based, and Cr-based materials. The deposition film 520 includes at least one of TiO₂ TiN, TiCN, and SiO₂ The deposition film 520 is formed by depositing at least one of a silicon oxide (SiO₂ film, a titanium oxide (TiO₂) film, an aluminum oxide (Al₂O₃) film, a zirconium oxide film, and (ZrO₂) tantalum oxide (Ta₂O₅) film. The deposition film 520 is formed by alternately forming two or more materials, for example, SiO₂-TiO₂, Al₂b-TiO₂, SiO₂-ZrO₂, Al₂O₃-ZrO₂, and SiO₂- Ta₂O₅.

Thereafter, in step 311, a second primer layer (for example, a urethane-based material) may be formed and cured on the disposition film 520 for forming a painting film 530 thereon.

In step 312, the painting film 530 is formed on the primer layer cured in step 313. The painting film 530 includes a base coating layer and a clear coating layer.

Buffing is formed immediately after the metal member 410 and the non-metal member 420, composed of dissimilar materials, are coupled to each other, but the present disclosure is not limited thereto. After the metal member 410 and the non-metal member 420 are coupled to each other and the primer layer is applied and cured on the coupled members as the concept of putty, buffing may be performed and then a deposition film may be formed on the buffed portion.

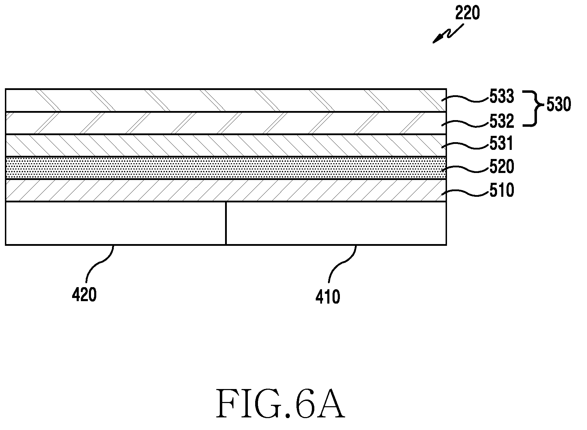

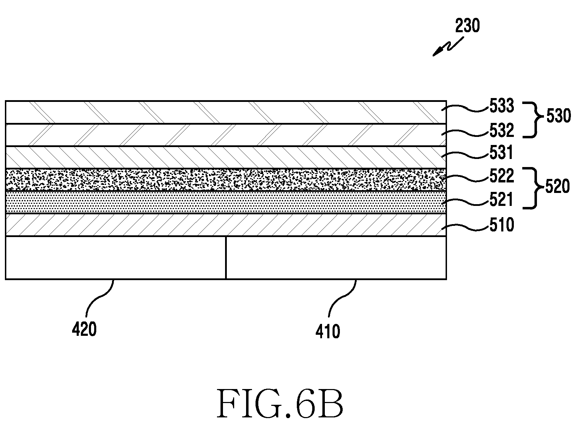

FIGs. 6A and 6B are sectional views of a housing of an electronic device, according to an embodiment of the present disclosure.

Referring to FIG. 6A, a first primer layer 510 is formed on the surface where the two members of dissimilar materials, for example, the metal member 410 and the non-metal member 420, are coupled through dual injection-molding. The first primer layer 510 is formed to have a thickness in a range of 30 µm to 40 µm. The deposition film 520 is formed on the first primer layer 510. The deposition film 520 may be formed to have a thickness in a range of 100 Å to 700 Å. The deposition film 520 may be formed of a metallic material to minimize reflectivity between the dissimilar materials and conceal the border portion. A second primer layer 531 for forming a painting film 530 is formed on the deposition layer 520. The painting film 530 includes a base coating layer 532 and a clear coating layer 533 which is formed on the second primer layer 531. The painting film 530 including the second primary layer 531 may be formed to have a thickness in a range of 30 µm to 40 µm.

The painting film 530 includes a basic color painting film coated on the second primer layer 531. A transparent film may be formed on the basic color painting film. The transparent film may be formed by ejecting a transparent urethane paint to protect the basic color painting film. A Soft Feel (SF) paint may be applied on the transparent film to naturally express a color of the basic color paint film.

Accordingly, in the present disclosure, because the thickness from the first primer layer 510 which is initially applied to the outer surface of the metal member 410 and the non-metal member 420 to the final painting film 530 may have a range of 70 µm to 80 µm, the thickness of the electronic device may be significantly reduced, as compared to that of the related art where the thickness from a primer layer formed on the upper surface of a housing to the final painting film is an average of 120 µm. Thus, the method of manufacturing the housing of an electronic device, according to the various embodiments of the present disclosure, contributes to an increased slimness of the electronic device and reduces the number of manufacturing processes.

Referring to FIG. 6B, the deposition film 520 has a plurality of layers, such as a first deposition film 521 and a second deposition film 522. The first deposition film 521 and the second deposition film 522 may be formed of different materials. The deposition film 520 may be deposited by alternately using two or more deposition materials. For example, the deposition film 520 may be formed by alternately depositing a first deposition material that achieves a first desired refractivity by mixing two or more deposition materials, and a second deposition material that achieves a second desired refractivity different from the first refractivity.

For example, the refractivity of the silicon oxide (SiO₂ film is 1.4, the refractivity of the titanium oxide (TiO₂) film is 2.4, and the refractivity of the aluminum oxide (Al₂O₃) film is 1.7. Accordingly, if the silicon oxide (SiO₂ film and the titanium oxide (TiO₂) film, having a large refractivity difference, are alternately deposited, it is very advantageous for a ceramic pearl texture effect and an anisotropic color reproduction effect.

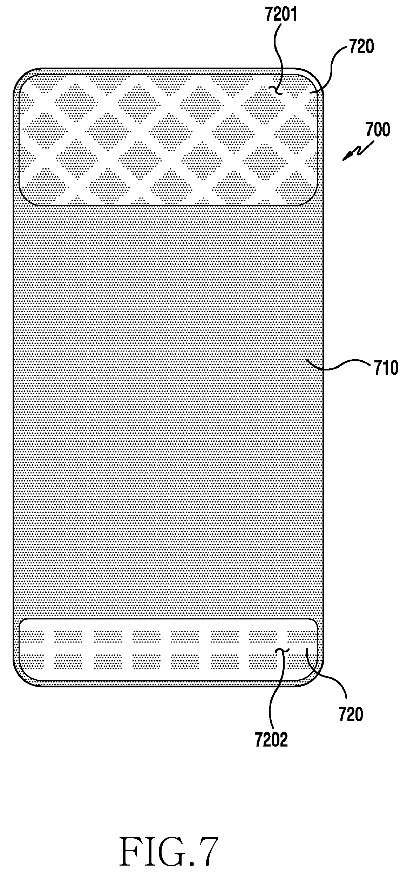

FIG. 7 is a view illustrating a pattern shape of a deposition film formed in a non-metal member of a housing of an electronic device, according to an embodiment of the present disclosure.

Referring to FIG. 7, illustrates a housing 700 having a metal member 710 and a non-metal member 720 is provided. The upper surface of the housing 700 is buffed and a deposition material is applied on the buffed surface to form a deposition film.

Non-metal member 720 is exposed to the upper and lower sides of the metal member 710. When the housing 700 is applied to a communication electronic device, at least one antenna radiation body may be arranged in an area of the metal member 710 in which the non-metal member 720 is exposed from the metal member 710. The deposition film may be coated with a metal material to lower radiation performance of the antenna radiation body. Accordingly, the deposition film of the metal member 710 formed in the area of the non-metal member 720 may include a pattern in the form of a mesh. However, the present disclosure is not limited thereto, and the deposition film may include various patterns having regular or irregular repeated periods. A signal of an operation band of the antenna radiation body may be radiated through the non-metal member 720 by the pattern.

According to various embodiments of the present disclosure, by coupling the members of dissimilar materials and forming a deposition film on the upper surface of the coupled members, a sense of difference between the dissimilar materials can be minimized and the difference between the transmissivities can be minimized, which can contribute to an appealing design and reduce manufacturing time and manufacturing cost with a relatively small number of processes.

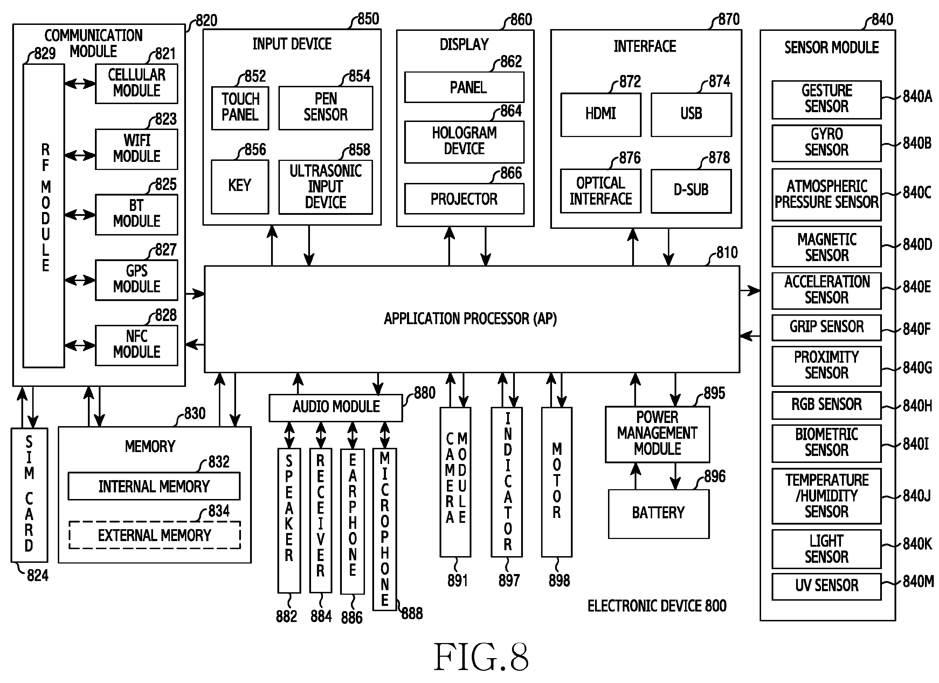

FIG. 8 is a block diagram illustrating a configuration of an electronic device, according to an embodiment of the present disclosure 800.

Referring to FIG. 8, an electronic device 800 is provided. The electronic device 800 may form the whole or a part of the electronic device 101 illustrated in FIG. 1. The electronic device 800 includes at least one Application Processor (AP) 810, a communication module 820, a Subscriber Identification Module (SIM) card 824, a memory 830, a sensor module 840, an input device 850, a display 860, an interface 870, an audio module 880, a camera module 891, a power management module 895, a battery 896, an indicator 897, and a motor 898.

The processor 810 drives an operating system or an application program so as to control a plurality of hardware or software components connected thereto, and also performs various data processing and arithmetic operations. The processor 810 may be implemented by, for example, a System-on-Chip (SoC). The processor 810 may further include a Graphic Processing Unit (GPU) and/or an image signal processor. The processor 810 may include at least some components (e.g., the cellular module 821) among the components illustrated in FIG. 8. The processor 810 loads and processes a command or data received from at least one of the other components (e.g., the non-volatile memory) in a volatile memory and stores various data in the non-volatile memory.

The communication module 820 may have a configuration that is the same as or similar to the communication interface 170 of FIG. 1. The communication module 820 includes, for example, a cellular module 821, a WiFi module 823, a Bluetooth module 825, a GPS module 827 (e.g., a GPS module, a Glonass module, a Beidou, or a Galileo module), an NFC module 828, and a Radio Frequency (RF) module 829.

The cellular module 821 provides a voice call, a video call, a message service, or an Internet service through a communication network. The cellular module 821 performs authentication of the electronic device 800 within the communication network by using the SIM card 824. The cellular module 821 may perform at least some of the multimedia control functions that may be provided by the processor 810. The cellular module 821 may include a Communication Processor (CP).

Each of the WiFi module 823, the BT module 825, the GPS module 827, and the NFC module 828 includes a processor to process data transmitted/received therethrough. At least some of the cellular module 821, the WiFi module 823, the Bluetooth module 825, the GPS module 827, and the NFC module 828 may be incorporated in a single Integrated Chip (IC) or an IC package.

The RF module 829 transmits/receives a communication signal (e.g., an RF signal). The RF module 829 may include a transceiver, a Power Amp Module (PAM), a frequency filter, a Low Noise Amplifier (LNA), or an antenna. Alternatively, at least one of the cellular module 821, the WiFi module 823, the Bluetooth module 825, the GPS module 827, and the NFC module 828 transmits/receives an RF signal through a separate RF module.

The SIM card 824 is a card that may be inserted into a slot formed on the electronic device 800. The SIM card 824 includes a SIM card and/or an embedded SIM. The SIM card includes unique identification information (e.g., Integrated Circuit Card IDentifier (ICCID)) or subscriber information (e.g., International Mobile Subscriber Identity (IMSI)).

The memory 830 (e.g., the memory 130) includes an internal memory 832 or an external memory 834.

The internal memory 832 includes at least one of, for example, a volatile memory (e.g., Dynamic RAM (DRAM), Static RAM (SRAM), or Synchronous DRAM (SDRAM)), a nonvolatile memory (e.g., One Time Programmable ROM (OTPROM), Programmable ROM (PROM), Erasable and Programmable ROM (EPROM), Electrically Erasable and Programmable ROM (EEPROM), mask ROM, flash ROM, flash memory (e.g., NAND flash memory, or NOR flash memory), hard drive, or Solid State Drive (SSD)).

The external memory 834 includes a flash drive, e.g., Compact Flash (CF), Secure Digital (SD), Micro Secure Digital (Micro-SD), Mini Secure Digital (Mini-SD), extreme Digital (xD), Multi-Media Card (MMC), or memory stick. The external memory 834 may be functionally and/or physically connected to the electronic device 800 through various interfaces.

The sensor module 840 measures a physical quantity or senses an operating status of the electronic device 800, and then converts the measured or sensed information into electric signals. The sensor module 840 includes at least one of, for example, a gesture sensor 840A, a gyro sensor 840B, an atmospheric pressure sensor 840C, a magnetic sensor 840D, an acceleration sensor 840E, a grip sensor 840F, a proximity sensor 840G, a Red, Green, Blue (RGB) (e.g., color) sensor 840H, a biometric sensor 840I, a temperature/humidity sensor 840J, an light (e.g., illuminance) sensor 840K, and a Ultra-Violet (UV) sensor 840M. Additionally or alternatively, the sensor module 840 may include an E-nose sensor, an ElectroMyoGraphy (EMG) sensor, an ElectroEncephaloGram (EEG) sensor, an ElectroCardioGram (ECG) sensor, an Infra-Red (IR) sensor, an iris sensor, or a fingerprint sensor. The sensor module 840 may further include a control circuit for controlling one or more sensors incorporated therein. The electronic device 800 may further include a processor configured to control the sensor module 840 as a part of the processor 810 or separate from the processor 810 so as to control the sensor module while the processor 810 is in the sleep state.

The input device 850 includes a touch panel 852, a (digital) pen sensor 854, a key 856, or an ultrasonic input device 858.

The touch panel 852 may use, at least one of, for example, a capacitive type touch panel, a resistive type touch panel, an infrared type touch panel, and an ultrasonic type panel. Also, the touch panel 852 may further include a control circuit. In addition, the touch panel 852 may further include a tactile layer so as to provide a tactile reaction to a user.

The (digital) pen sensor 854 may be, for example, a part of the touch panel or may include a separate recognition sheet.

The key 856 may include, for example, a physical button, an optical key, or a keypad.

The ultrasonic input device 858 senses, through a microphone 888, ultrasonic waves that are generated by an input tool so that data corresponding to the sensed ultrasonic waves can be confirmed.

The display 860 (e.g., the display 160) includes a panel 862, a hologram device 864, or a projector 866.

The panel 862 may include a configuration that is the same as or similar to that of the display 160 of FIG. 1. The panel 862 may be implemented to be flexible, transparent, or wearable. The panel 862 may be configured as a single module with the touch panel 852.

The hologram device 864 displays a stereoscopic image in the air using interference of light.

The projector 866 projects light onto a screen so as to display an image. The screen may be located inside or outside the electronic device 800. The display 860 may further include a control circuit to control the panel 862, the hologram device 864, or the projector 866.

The interface 870 includes, for example, a High-Definition Multimedia Interface (HDMI) 872, a Universal Serial Bus (USB) 874, an optical interface 876, or a D-subminiature (D-sub) 878. The interface 870 may be included in the communication interface 170 illustrated in FIG. 1. Additionally or alternatively, the interface 870 may include, for example, a Mobile High-definition Link (MHL) interface, a Secure Digital (SD) card/Multi-Media Card (MMC) interface, or an Infrared Data Association (IrDA) standard interface.

The audio module 880 bi-directionally converts sounds and electric signals. At least some of the components of the audio module 880 may be included in the input/output interface 80050 illustrated in FIG. 1. The audio module 880 processes sound information input or output through, for example, a speaker 882, a receiver 884, an earphone 886, or the microphone 888.

The camera module 891 is a device capable of photographing a still image and a moving image. The camera module 891 includes at least one image sensor (e.g., a front sensor or a rear sensor), a lens, an Image Signal Processor (ISP), or a flash (e.g., LED or xenon lamp).

The power management module 895manages the electric power of the electronic device 800. The power management module 895 may include a Power Management Integrated Circuit (PMIC), a charger Integrated Circuit (IC), or a battery gauge. The PMIC may be configured in a wired and/or wireless charge type. The wireless charge type includes, for example, a magnetic resonance type, a magnetic induction type, or an electromagnetic wave type, and may further include an additional circuit for wireless charge, such as a coil loop, a resonance circuit, or a rectifier. The battery gauge measures the residual amount, a voltage, current, or a temperature during the charge of the battery 896. The battery 896 stores or creates electric power and supplies the electric power to the electronic device 800. The battery 896 may include, for example, a rechargeable battery and/or a solar battery.

The indicator 897 indicates a specific status of the electronic device 800 or of a part thereof, such as a booting status, a message status, or a charged status.

The motor 898 converts an electric signal into a mechanical vibration, and generates a vibration or a haptic effect.

The electronic device 800 includes a processor (e.g., GPU) to support a mobile TV. The processor to support a mobile TV processes media data that complies with the standards of, for example, Digital Multimedia Broadcasting (DMB), Digital Video Broadcasting (DVB), or mediaFlo™.

Each of the above-described component elements of hardware according to the present disclosure may be configured with one or more components, and the names of the corresponding component elements may vary based on the type of electronic device. The electronic device according to various embodiments of the present disclosure may include at least one of the aforementioned elements. Some elements may be omitted or other additional elements may be further included in the electronic device. Also, some of the hardware components according to various embodiments may be combined into one entity, which may perform functions identical to those of the relevant components before the combination.

Although specific embodiments have been described in the detailed description of the present disclosure, various changes and modifications may be made without departing from the scope of the present disclosure. Therefore, the scope of the present disclosure should not be defined as being limited to the embodiments, but should be defined by the appended claims and their equivalents.

## Claims

1. A method of manufacturing a housing (220) of an electronic device (200), the method comprising:
forming a basic material (410, 420) of the housing (220) by coupling members of the housing composed of dissimilar materials;
planarizing a coupling surface of the basic material of the housing (220);
forming at least one deposition film (520) on the planarized surface; and
forming a painting film (530) on the at least one deposition film (520).

2. The method of claim 1, wherein the basic material of the housing is formed by coupling a metal member and a non-metal member through at least one of dual injection-molding, insert injection-molding, and structural coupling.

3. The method of claim 1, wherein the coupling surface is planarized through buffing.

4. The method of claim 1, further comprising:
laminating a primer layer on the planarized surface of the basic material of the housing before forming the at least one deposition film.

5. The method of claim 4, wherein the primer layer is formed of at least one of olefin-based, acryl-based, and urethane-based materials.

6. The method of claim 4, wherein a thickness of the primer layer has a range of 30 µm to 40 µm.

7. The method of claim 1, wherein the at least one deposition film is formed of at least one of Ti-based, Sn-based, and Cr-based materials.

8. The method of claim 1, wherein the at least one deposition film comprises two or more deposition films, and the two or more deposition films are formed of materials having different refractivities.

9. The method of claim 1, wherein a thickness of the at least one deposition film has a range of 100 Å to 700 Å.

10. An electronic device (200) comprising:
a housing (220) forming at least a portion of an external surface of the electronic device (200), wherein
the housing (220) comprises:
a first member (410) ;
a second member (420) coupled to the first member (410) to form a basic material of the housing (220) ;
a primer layer (510) laminated on the basic material of the housing (220) ;
at least one deposition film (520) laminated on the primer layer (510) ; and
a painting film (530) laminated on the at least one deposition film (520).

11. The electronic device of claim 10, wherein the first member is a metal member and the second member is a non-metal member.

12. The electronic device of claim 11, wherein the basic material of the housing is formed by coupling the first member and the second member through at least one of dual injection-molding, insert injection-molding, and structural coupling.

13. The electronic device of claim 10, wherein the at least one deposition film is formed of at least one of Ti-based, Sn-based, and Cr-based materials.

14. The electronic device of claim 10, wherein the at least one deposition film comprises two or more deposition films, and the two or more deposition films are formed of materials having different refractivities.

15. The electronic device of claim 10, wherein a thickness of the deposition film has a range of 100 Å to 700 Å.
